# EUROPÄISCHE PATENTSCHRIFT

(11) **EP 1 340 994 B1**
(45) Veröffentlichungstag und Bekanntmachung des Hinweises auf die Patenterteilung: **28.11.2007**
(21) Anmeldenummer: 03003620.6
(22) Anmeldetag: 17.02.2003
(51) Int. Cl.: G01R 33/389

(54) **Verfahren zum Betrieb eines Magnetresonanzgeräts sowie Magnetresonanzgerät**
Method of operating a magnetic resonance apparatus and magnetic resonance apparatus
Méthode d'utilisation d'un appareil de résonance magnétique et appareil de résonance magnétique

(30) Priorität: 01.03.2002 DE 10209089
(43) Veröffentlichungstag der Anmeldung: 03.09.2003
(73) Patentinhaber: SIEMENS AKTIENGESELLSCHAFT, 80333 München (DE)
(72) Erfinder: Bechtold, Mario, 91341 Hemhofen (DE); Kimmlingen, Ralph, 90451 Nürnberg (DE); Ries, Günter, Dr., 91056 Erlangen (DE); Röckelein, Rudolf, 91058 Erlangen (DE)

(56) Entgegenhaltungen:
- EP-A- 1 043 598
- WO-A-00/16116
- JP-A- 8 215 168
- US-A- 4 663 592

## Beschreibung

Die Erfindung betrifft ein Verfahren zum Betriebs eines Magnetresonanzgeräts.

Die Magnetresonanztomographie basiert auf dem physikalischen Phänomen der Kernspinresonanz und wird als bildgebendes Verfahren seit vielen Jahren in der Medizin und der Biophysik erfolgreich eingesetzt. Bei dieser Untersuchungsmethode wird das Untersuchungsobjekt einem starken konstanten Magnetfeld, einem sogenannten Grundfeld ausgesetzt. Dadurch richten sich die Kernspins der Atome in dem Objekt, welche vorher regellos orientiert waren, aus. Hochfrequenzwellen können nun diese "geordneten" Kernspins zu einer bestimmten Schwingung anregen. Diese Schwingung erzeugt in der Tomographie das eigentliche Messsignal, welches mittels geeigneter Empfangsspulen aufgenommen wird. Um das Messobjekt in allen drei Raumrichtungen räumlich codiert aufnehmen zu können, ist ein Gradientenspulensystem vorgesehen, das in der Regel drei separate Gradientenspulen (x-, y- und z-Spulen) umfasst, über die separate ortsabhängige Magnetfelder erzeugt werden können.

Zentrale physikalische Phänomene bei einem Magnetresonanztomographen sind also die Magnetfelder. Sie sind auch ursächlich für die Qualität der aufgenommenen Bilder und letztlich für die damit erstellbare Diagnose. In einem Magnetresonanztomographen gibt es jedoch eine Reihe von Bauteilen (Permanentmagnete, Shimeisen etc.) mit temperaturabhängiger Magnetisierung. Bei Temperaturschwankungen dieser Bauteile wird die Homogenität des Grundfelds gestört. Diese Teile müssen deshalb in ihrer Temperatur stabil gehalten werden, da eine softwareseitige Kompensation des Einflusses dieser üblicherweise großflächigen Teile auf das Grundfeld nur bedingt möglich ist und es infolgedessen bei einer Feldvariation zu unbrauchbaren Bildaufnahmen kommen kann.

Ein dynamischer Wärmeeintrag erfolgt z.B. durch Schwankungen in der Raum- oder Kühlwassertemperatur, durch die zeitabhängigen ohmschen Verluste in den Gradientenspulen oder über Wirbelstromverluste in den Bauteilen selbst. Bei den derzeit geplanten Anwendungen beispielsweise in einem geschlossenen MR-System darf die Bauteiltemperatur nur weniger als 0,5 K/10 Minuten schwanken, andererseits sind Leistungseinträge im Bereich von 200 - 300 W/m² jetzt schon Realität.

Zur Homogenisierung des Grundmagnetfelds ist es bekannt, ein Shim-System umfassend mehrere Shimeisen zu verwenden, die in der Regel am Gradientenspulensystem angeordnet sind. Die Shimeisen selbst sind jedoch temperatursensitive Elemente, d.h. sie werden im Betrieb erwärmt. Aufgrund der Erwärmung ändert sich ihr magnetisches Verhalten, was sich nachteilig auf das Grundfeld auswirkt. Auch eine Lageänderung der Shimeisen durch mechanische Verformung ist aufgrund der Temperaturabhängigkeit der Fixierung möglich, insbesondere auch hervorgerufen durch die Erwärmung anderer Teile, die mit den Shimeisen mechanisch verbunden sind.

Es ist bekannt, durch eine aktive Beheizung der Shimeisen die Temperatur der Shimeisen konstant zu halten, so dass sich die genannten, temperaturänderungsbedingten Einflüsse weitgehend kompensieren lassen, siehe z.B. JP-08 215 168 A.

Wenngleich sich hierdurch eine deutliche Verbesserung der zeitlichen und örtlichen Feldhomogenität erreichen lässt, zeigen Bildsequenzen, dass trotz allem Feldänderungen im Betrieb des Geräts auch bei weitgehender Temperaturkonstanz der Shimeisen auftreten und sich die Bildqualität verschlechtert.

Der Erfindung liegt das Problem zugrunde, ein Verfahren anzugeben, das die örtliche und zeitliche Stabilität der Grundfeldhomogenität bei Betrieb des Magnetresonanzgeräts weiter verbessert.

Zur Lösung dieses Problems ist ein Verfahren zum Betrieb eines Magnetresonanzgeräts umfassend ein Gradientenspulensystem sowie ein Shim-System umfassend mehrere Shimeisen mit jeweils einem zugeordneten Heizmittel vorgesehen, bei welchem Verfahren wenigstens ein eine Formund/oder Lageänderung des Gradientenspulensystems anzeigendes Informationssignal ermittelt oder verwendet wird, in dessen Abhängigkeit die Regelung der Heizmittel und damit der Temperatur der Shimeisen erfolgt.

Die Regelung der Heizmittel bzw. der Shimeisentemperatur erfolgt erfindungsgemäß in Abhängigkeit eines Informationssignals, das ein Maß für eine Form- und/oder Lageänderung des Gradientenspulensystems ist. Es hat sich nämlich herausgestellt, dass aufgrund der im Betrieb einsetzenden Erwärmung des Gradientenspulensystems eine Lageänderung der Shimeisen eintritt, was zu einer Verschlechterung der Grundfeldhomogenität führt. Es setzt also ein Felddrift ein, die sich nachteilig auf die aufgenommenen Bildsequenzen auswirkt. Indem diese Form- oder Lageänderung erfasst und in die Temperaturregelung eingeht, kann diese Felddrift im Rahmen der Homogenisierung des Feldes über die Shimeisen berücksichtigt werden, da entsprechend der geregelten Shimeisentemperatur eine Beeinflussung der Sättigungsinduktion der Shimeisenbleche möglich ist, die ihrerseits wieder eine Kompensation der Felddrift zulässt. Gleichzeitig bleibt hierbei natürlich auch die Temperaturstabilisierung der Shimeisenbleche Ziel des Heizbetriebes. D.h. es ist möglich, sowohl die Temperatur zu stabilisieren als auch die stabilisierte Temperatur so zu wählen, dass etwaige geometriebedingte Änderungen der Magnetfelder hierdurch kompensiert werden können. Aufgrund der individuellen Regelung der einzelnen Shimeisen kann so eine hinreichend aufgelöste zeitliche und örtliche Kompensation erfolgen.

Nach einer ersten Erfindungsausgestaltung kann vorgesehen sein, dass das oder die Informationssignale unter Verwendung eines oder mehrerer Messelemente ermittelt werden. Das oder die Messelemente können dabei das oder die mittels des Gradientenspulensystems erzeugten Magnetfelder erfassen, d.h. es werden etwaige sich in situ ergebende Feldänderungen unmittelbar erfasst, z.B. Marker mit der MR-Bildgebung. Alternativ oder zusätzlich können das oder die Messelemente auch die Temperatur des Gradientenspulensystems erfassen, d.h. es sind entsprechende Temperatursensoren am Gradientenspulensystem (das in der Regel die Spulen und einen Träger, in der Regel ein GFK-Rohr oder eine GFK-Platte, in die die Spulen eingegossen sind, umfasst) vorgesehen, worüber die Temperatur ermittelt wird. Eine weitere Alternative sieht vor, dass als Messelemente am Gradientenspulensystem - also z.B. dem GFK-Rohr - angeordnete Dehnungssensoren verwendet werden, die die Informationssignale liefern. Dabei sind die Dehnungssensoren, von denen vornehmlich eine Vielzahl vorgesehen ist, entsprechend so angeordnet oder ausgerichtet, dass unterschiedliche Verformungsarten, also Dehnungen, Stauchungen und Längenänderungen, erfasst werden können. Es ist natürlich möglich, mehrere unterschiedliche Informationssignale aufzunehmen und im Rahmen der Regelung zu verarbeiten.

Die mehreren Messelemente sind über das Gradientenspulensystem vorzugsweise homogen verteilt angeordnet, so dass lokal aufgelöste Informationssignale erfasst werden, um eine exakte zeitliche und örtliche aufgelöste Regelung zu ermöglichen.

Eine besonders zweckmäßige Erfindungsausgestaltung sieht vor, die mehreren Messelemente an der Außenseite und der Innenseite des Gradientenspulensystems vorzugsweise homogen verteilt anzuordnen, so dass lokal ortsaufgelöste Informationssignale von der Außenseite und der Innenseite erfasst werden können. Die Spulen des Gradientenspulensystems sind zumindest abschnittsweise übereinander angeordnet, d.h. sie liegen unterschiedlich weit vom Zentrum des Messobjekts beabstandet. Eine Erfassung an beiden Seiten des Gradientenspulensystems ermöglicht eine genauere Parameter- bzw. Informationssignalaufnahme und damit Erfassung etwaiger Änderungen, da hierdurch möglichst nahe an allen Spulen des Systems die Parameter- oder Signalaufnahme erfolgt. Dies ist insbesondere dann zweckmäßig, wenn die Shimeisen ebenfalls an der Außen- und der Innenseite vorgesehen sind, so dass, wenn also beispielsweise die außenliegende z-Spule Schwierigkeiten bereitet, das oder diejenigen Shimeisenbleche, die ihr an der Außenseite möglichst nahe benachbart sind, entsprechend geregelt werden können.

Eine Alternative zur Erfassung des oder der Informationssignale über geeignete Messelemente liegt darin, als Informationssignal wenigstens einen Betriebsparameter des Gradientenspulensystems zu verwenden. Da die Form- und/oder Lageänderungen des Gradientenspulensystems im Wesentlichen aus dem Betrieb desselben resultieren, können anhand des oder der relevanten Betriebsparameter, insbesondere des Betriebsstromes, Rückschlüsse auf die Spulen- oder Systemtemperatur und darüber auf etwaige Form- oder Lageänderungen gezogen werden, die in die Regelung eingehen. Wie gesagt ist ein zweckmäßiger Betriebsparameter der Betriebsstrom, d.h. es erfolgt eine Berücksichtigung der Stromsequenzen der Spulen.

Als weiterer Betriebsparameter kann ein ein Maß für die Kühlung des Gradientenspulensystems darstellender Betriebsparameter verwendet werden. Das Gradientenspulensystem wird trotz aktiver Zusatzheizung nach wie vor über eine Kühleinrichtung gekühlt, deren Betriebsparameter naturgemäß ebenfalls einen Einfluss auf den Temperaturgang des Gradientenspulensystems haben. Als Betriebsparameter kann dabei jeder Parameter, der die Kühlung bzw. die Kühlleistung in irgendeiner Form beschreibt, verwendet werden.

Eine zweckmäßige Erfindungsalternative sieht des Weiteren vor, das Informationssignal durch eine Analyse eines oder mehrerer mit dem Magnetresonanzgerät empfangener Anregungsantworten zu ermitteln. Eine sich ergebende Feldinhomogenität äußert sich sehr schnell innerhalb einer aufgenommenen Bildsequenz, so dass durch die Bildanalyse quasi in situ die Feldänderung erfasst, in ihrer Qualität und Art bestimmt und ein entsprechendes Informationssignal ausgegeben werden kann.

Weiterhin ist es zweckmäßig, wenn im Rahmen der Temperaturregelung auch der Energieverbrauch der shimeisenseitigen Regeleinrichtungen berücksichtigt wird. Die Regeleinrichtungen verbrauchen ebenfalls Energie und erwärmen sich. Ihr Wärmebeitrag kann im Rahmen der Gesamtregelung ebenfalls Berücksichtigung finden.

In einer konkreten Ausprägung des Regelverfahrens kann vorgesehen sein, abhängig von dem wenigstens einen Informationssignal einen Temperatursollwert zu wählen, auf den die Ist-Temperatur der Shimeisen eingeregelt wird. Hierzu kann beispielsweise eine Lookup-Tabelle verwendet werden, aus der der geeignete Sollwert in Abhängigkeit des oder der vorliegenden Informationssignale gewählt wird. Der Sollwert wird der Regeleinrichtung gegeben, die dann das Heizmittel entsprechend ansteuert.

Neben dem Verfahren betrifft die Erfindung ferner ein Magnetresonanzgerät, umfassend ein Gradientenspulensystem sowie ein Shim-System umfassend mehrere Shimeisen mit jeweils einem zugeordneten Heizmittel und Regelungseinrichtung, wobei der Betrieb der Heizmittel und damit die Temperatur der Shimeisen in Abhängigkeit wenigstens eines eine Formund/oder Lageänderung des Gradientenspulensystems anzeigenden Informationssignals regelbar ist.

Die Regelungseinrichtung ist nach einer Erfindungsausgestaltung zum Regeln auf Basis eines ein Maß für einen Temperatur-Sollwert darstellenden Sollwertsignals, das in Abhängigkeit des Informationssignals bestimmt ist, ausgebildet, d.h. der Regelungseinrichtung wird ein Sollwertsignal gegeben, in Abhängigkeit dessen die Regelung des Heizmittels erfolgt. Zum Bestimmen des Sollwertssignals ist zweckmäßigerweise eine Steuerungseinrichtung vorgesehen, der das oder die Informationssignale gegeben werden und die mit den Regelungseinrichtungen kommuniziert. In der Steuerungseinrichtung ist zweckmäßigerweise eine Lookup-Tabelle abgelegt, aus der in Abhängigkeit des oder der Informationssignale der Temperatur-Sollwert gewählt und in Form des Sollwertsignals an die Regelungseinrichtung gegeben wird.

Im Hinblick auf die bezogen auf das Untersuchungsobjekt unterschiedlich weit beabstandeten Gradientenspulen ist es zweckmäßig, wenn jedem Shimeisen zwei regelbare Heizmittel zugeordnet sind, die an einander gegenüber liegenden Seiten des Shimeisens angeordnet und über die gemeinsame Regelungseinrichtung separat regelbar sind. Da insbesondere im offenen System die Shimeisen zwischen zwei Gradientenspulen angeordnet sind, befindet sich also jeweils ein Heizmittel relativ nahe an einer Gradientenspule, so dass ein möglichst direkter Heizbetrieb möglich ist.

Zur Erfassung des oder der Informationssignale können ein oder mehrere Messelemente, die gegebenenfalls mit der Steuerungseinrichtung kommunizieren, vorgesehen sein. Die Messelemente können zur Erfassung der mittels des Gradientenspulensystems erzeugten Magnetfelder, zur Erfassung der Temperatur des Gradientenspulensystems oder zur Erfassung etwaiger Dehnungen oder Stauchungen und dergleichen des Gradientenspulensystems ausgebildet sein. Sie sind zweckmäßigerweise homogen verteilt über das Gradientenspulensystem angeordnet, so dass lokal aufgelöste Informationssignale erfassbar sind. Schließlich können die mehreren Messelemente sowohl an der Außenseite als auch der Innenseite des Gradientenspulensystems vorzugsweise homogen verteilt angeordnet sein, so dass lokal aufgelöste Informationssignale von beiden Seiten erfasst werden können.

Alternativ oder zusätzlich kann als Informationssignal auch wenigstens ein Betriebsparameter, insbesondere der Betriebsstrom des Gradientenspulensystems verwendet werden, auch ein Betriebsparameter, der ein Maß für die Kühlung des Gradientenspulensystems darstellt, kann als Informationssignal verarbeitet werden.

Schließlich können beim erfindungsgemäßen Magnetresonanzgerät Mittel zur Ermittlung des Informationssignals durch eine Analyse eines oder mehrerer mit dem Magnetresonanzgerät aufgenommener Bilder vorgesehen sein, die gegebenenfalls mit der Steuerungseinrichtung kommunizieren.

Die Heizmittel können als Folienheizung mit einer Trägerfolie mit aufgebrachten Heizleitern, als Platinenheizung mit einer Trägerplatine mit aufgebrachten Heizleitern oder als Substratheizung mit einem vorzugsweise keramischen, insbesondere Al₂O₃-Substrat mit aufgebrachten Heizleitern ausgebildet sein. Diese sehr flachen Heizmittel ermöglichen es, die Shimeisen trotz integrierter Heizung relativ klein zu bauen. Die Heizleiter selbst sind zur Unterdrückung von während ihres Betriebs erzeugbaren Magnetfeldern zweckmäßigerweise bifilar verlaufend angeordnet, d.h. es gibt jeweils eine Hin- und eine Rückleitung, so dass sich stromflussbedingte Magnetfelder gegenseitig kompensieren.

Weiter Vorteile, Merkmale und Einzelheiten der Erfindung ergeben sich aus dem im folgenden beschriebenen Ausführungsbeispiel sowie anhand der Zeichnungen. Dabei zeigen:
- Fig. 1: eine Prinzipskizze der relevanten felderzeugenden Teile eines Magnetresonanzgeräts,
- Fig. 2: eine Prinzipskizze der Temperaturregelung der Shimeisen, und
- Fig. 3: eine Schnittansicht eines Shimeisens.

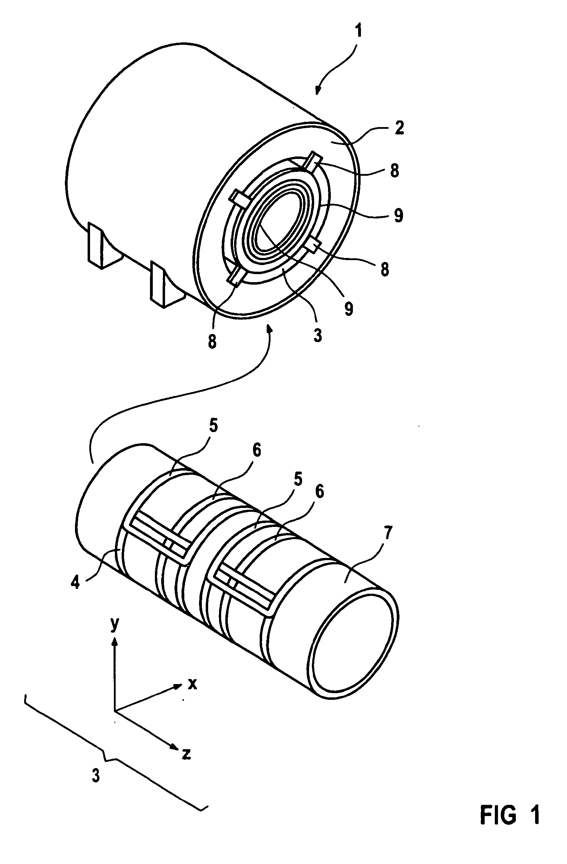

Fig. 1 zeigt ein erfindungsgemäßes Magnetresonanzgerät 1, wobei hier nur die relevanten felderzeugenden Elemente dargestellt sind. Gezeigt ist ein Grundfeldmagnet 2 (z.B. ein axialer supraleitender Luftspulenmagnet mit aktiver Streufeldabschirmung), der in einem Innenraum ein homogenes magnetisches Grundfeld erzeugt. Der supraleitende Grundfeldmagnet 2 besteht im Inneren aus supraleitenden Spulen, die sich in flüssigem Helium befinden. Der Grundfeldmagnet 1 ist von einem zweischaligen Kessel, der in der Regel aus Edelstahl ist, umgeben. Der innere Kessel, der das flüssige Helium beinhaltet und zum Teil auch als Wicklungskörper für die Magnetspulen dient, ist über schwach wärmeleitende GFK-Stäbe am äußeren Kessel, der Raumtemperatur hat, aufgehängt. Zwischen innerem und äußerem Kessel herrscht Vakuum. Mittels Tragelementen 8 ist das zylinderförmige Gradientenspulensystem 3 in den Innenraum des Grundfeldmagneten 2 in das Innere eines Tragrohrs konzentrisch eingesetzt. Das Tragrohr ist nach außen und nach innen durch zwei innere Schalen 9 abgegrenzt.

Das Gradientenspulensystem 3 besitzt drei Teilwicklungen, die ein dem jeweils eingeprägten stromproportionales räumlich jeweils zueinander senkrecht stehendes Gradientenfeld erzeugt. Wie in Fig. 1 dargestellt umfasst das Gradientenspulensystem 3 eine x-Spule 4, eine y-Spule 5 und eine z-Spule 6, die jeweils um einen Spulenkern 7 (z.B. ein GFK-Rohr) gewickelt sind und so ein Grundfeld zweckmäßigerweise in Richtung der karthesischen Koordinaten x, y, z erzeugen. Jede dieser Spulen ist mit einer eigenen Stromversorgung ausgestattet, um unabhängige Strompulse entsprechend der in der Pulssequenzsteuerung programmierten Folge amplituden- und zeitgenau zu erzeugen. Die erforderlichen Ströme liegen bei etwa 250 - 450A. Da die Gradientenschaltzeiten so kurz wie möglich sein sollen, sind Stromanstiegsraten in der Größenordnung von 250kA/s nötig.

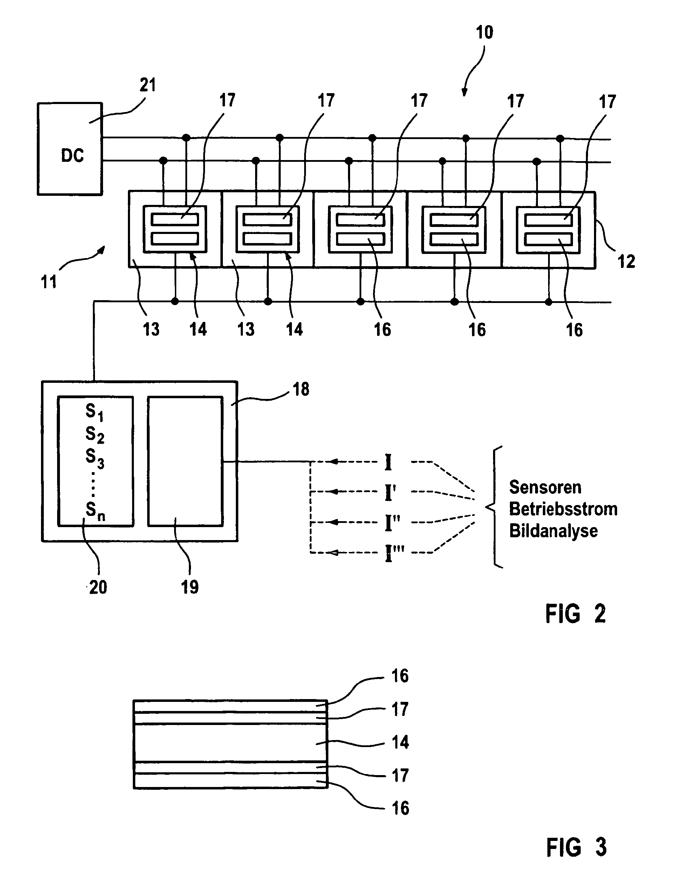

Da die Gradientenspulen in aller Regel von leitfähigen Strukturen umgeben ist (z.B. Magnetgefäß aus Edelstahl), werden in diesen durch die gepulsten Felder Wirbelströme erzeugt, die wiederum in Wechselwirkung mit dem Grundmagnetfeld treten und dieses verändern. In der Magnetresonanztomographie ist die durch die Homogenität des Grundfeldes im Messvolumen von elementarer Bedeutung. Um dieses zu homogenisieren, ist ein Shimsystem 10 vorgesehen, von dem in Fig. 2 ein Ausschnitt gezeigt ist. Dieses Shimsystem umfasst mehrere konzentrisch um die Gradientenspule angeordnete Shimeinrichtungen 11, von denen eine in Fig. 2 gezeigt ist. Die Shimeinrichtung umfasst eine thermisch und elektrisch nicht leitende Trägerschiene 12, vornehmlich ein Spritzgussteil, z.B. aus GFK-Material, in der mehrere kammerartige Aufnahmen 13 ausgebildet sind, in denen jeweils ein Shimeisen 14 angeordnet ist. Jedes Shimeisen, von denen eines in Fig. 3 vergrößert gezeigt ist, besteht zum einen aus dem eigentlichen Shimeisen 14. Im Beispiel gemäß Fig. 3 sind an jeder Seite des Shimeisens 14 jeweils eine Regelungseinrichtung 16 und ein über dieses geregelte Heizmittel 17 vorgesehen. Zwischen dem Shimeisen 14 und dem Heizmittel, bei dem es sich beispielsweise um eine Folienheizung, eine Platinenheizung oder eine Substratheizung handeln kann, bei denen jeweils auf die Folie, die Platine oder das Substrat Heizleiter (z.B. mäanderförmig) aufgebracht sind, kann eine nicht-magnetische wärmeleitende Platte vorgesehen sein, die in Fig. 3 nicht im Detail gezeigt ist. Auf der gleichen Seite wie die Spule befindet sich ein nicht näher gezeigter Temperatursensor, der die Temperatur des Shimeisens direkt oder indirekt (über die zwischengeordnete Platte) erfasst. Der Temperatursensor ist mit der Regelungseinrichtung 16 verbunden, die den Betrieb des Heizmittels regelt, um so die Temperatur des Shimeisens auf eine vorgegebene Sollwert-Temperatur einzuregeln, worauf nachfolgend noch eingegangen wird.

Nachdem jedes Shimeisen 14 über separate Heizmittel 17 verfügt ist es also möglich, eine separate Temperaturführung jedes Shimeisens zu realisieren. Auf diese Weise kann zum einen eine Temperaturkonstanthaltung der Shimeisenbleche erfolgen, was für die Homogenisierung des Grundfeldes erforderlich ist. Darüber hinaus kann durch die individuelle Steuerungsmöglichkeit auch etwaigen Form- und/oder Lageänderungen der Gradientenspulen bzw. des Gradientenspulensystems umfassend die Spulen 4, 5 und 6 sowie den Spulenkern 7 reagiert werden. Im Betrieb sind die Gradientenspulen hohen Strömen unterworfen, die zu einer starken Erwärmung und mithin einer Form- und Längenänderung führen. Dies hat nachteilige Auswirkungen auf die Homogenität des Grundmagnetfelds.

Um hier gegen zu wirken werden, siehe Fig. 2, auf verschiedenen Möglichkeiten Informationssignale I, I', I' ' und I ' ' ' ermittelt, die Informationen darüber liefern, ob eine Form- und/oder Lageänderung des Gradientenspulensystems eintritt. Diese Informationssignale - von denen bereits eines ausreichend sein kann - werden beispielsweise über Sensoren, die an dem Gradientenspulensystem, vornehmlich dem Spulenkern 7, vorzugsweise homogen verteilt angeordnet sind, aufgenommen. Als Sensoren können beispielsweise Temperatursensoren, Magnetfeldsensoren (die die von den Gradientenspulen erzeugten Magnetfelder erfassen) oder aber Dehnungssensoren verwendet werden. Gleichermaßen kann ein Informationssignal auch in Form eines Betriebsparameters der Gradientenspulen verwendet werden. Beispielsweise ist hier der Betriebsstrom der Spulen zu nennen, es wird also die Strom- oder Pulssequenz der Spulen berücksichtigt. Alternativ oder zusätzlich ist es auch möglich, aus den mit dem Magnetresonanzgerät 1 aufgenommenen Bildern im Rahmen einer Bildanalyse etwaige Form- und/oder Lageänderungen zu analysieren, die sich in Bildänderungen ausdrücken. Hierzu sind geeignete Analysealgorithmen zu verwenden.

Das oder die Informationssignale I, ...., I' ' ' werden an eine Steuerungseinrichtung 18 gegeben, die über eine Verarbeitungseinrichtung 19 verfügt, die das oder die Informationssignale verarbeitet. Je nach Qualität der Informationssignale wählt nun die Verarbeitungseinrichtung 19 aus einer Lookup-Tabelle 20 einen zur Temperaturkonstanthaltung und gleichzeitigen Kompensation einer aus einer Form- und/oder Lageänderung des Gradientenspulensystems resultierenden Felddrift dienenden Temperatur-Sollwert S₁, ₂ ....ₙ aus. Dieser ausgewählte Temperatur-Sollwert wird an jede Regelungseinrichtung 16 gegeben, von denen in Fig. 2 exemplarisch jeweils eine gezeigt ist. In der Regelungseinrichtung 16 wird nun der gegebene Temperatur-Sollwert mit dem über den Temperatursensor am Shimeisen 14 gemessenen Temperatur-Istwert verglichen und
eine entsprechende Regelung des Betriebs der Heizmittel 17, von denen in Fig. 2 ebenfalls nur eines pro Shimeisen 14 dargestellt ist, geregelt. Die Heizmittel sind mit einer geeigneten Stromquelle 21 verbunden, über die die Bestromung zu Heizzwecken erfolgt.

D.h. die Regelung der Heizmittel und damit die Einstellung der Temperatur der Shimeisen erfolgt in Abhängigkeit wenigstens eines Informationssignals, das eine Form- und/oder Lageänderung des Gradientenspulensystems indiziert, um hieraus resultierende Inhomogenitäten des Grundmagnetfeldes kompensieren zu können. Gleichzeitig erfolgt durch die direkte Beheizung der Shimeisen 14 eine hinreichende Temperaturkonstanthaltung, soweit dies erforderlich ist.

## Patentansprüche

1. Verfahren zum Betrieb eines Magnetresonanzgeräts umfassend ein Gradientenspulensystem sowie ein Shim-System umfassend mehrere Shimeisen mit jeweils einem zugeordneten Heizmittel, **gekennzeichnet dadurch, dass**
wenigstens ein eine Form- und/oder Lageänderung des Gradientenspulensystems anzeigendes Informationssignal ermittelt oder verwendet wird, in dessen Abhängigkeit die Regelung der Heizmittel und damit der Temperatur der Shimeisen erfolgt.

2. Verfahren nach Anspruch 1, bei welchem das oder die Informationssignale unter Verwendung eines oder mehrere Messelemente ermittelt werden.

3. Verfahren nach Anspruch 2, bei welchem das oder die Messelemente das oder die mittels des Gradientenspulensystems erzeugten Magnetfelder erfassen.

4. Verfahren nach Anspruch 2 bei welchem das die Messelemente die Temperatur des Gradientenspulensystems erfassen.

5. Verfahren nach Anspruch 2, bei welchem als Messelemente am Gradientenspulensystem angeordnete Dehnungssensoren verwendet werden, die die Informationssignale liefern.

6. Verfahren nach einem der Ansprüche 2 bis 5, bei welchem die mehreren Messelemente über das Gradientenspulensystem vorzugsweise homogen verteilt angeordnet sind, so dass lokal aufgelöste Informationssignale erfasst werden.

7. Verfahren nach Anspruch 6, bei welchem die mehreren Messelemente an der Außenseite und der Innenseite des Gradientenspulensystems vorzugsweise homogen verteilt angeordnet sind, so dass lokal ortsaufgelöste Informationssignale von der Außenseite und der Innenseite erfasst werden.

8. Verfahren nach einem der vorangehenden Ansprüche, bei welchem als Informationssignal wenigstens ein Betriebsparameter des Gradientenspulensystems verwendet wird.

9. Verfahren nach Anaspruch 8, bei welchem als Betriebsparameter der Betriebsstrom des Gradientenspulensystems verwendet wird.

10. Verfahren nach Anspruch 9, bei welchem als weiterer Betriebsparameter ein ein Maß für die Kühlung des Gradientenspulensystems darstellender Betriebsparameter verwendet wird.

11. Verfahren nach einem der vorangehenden Ansprüche, bei welchem das Informationssignal durch eine Analyse eines oder mehrerer mit dem Magnetresonanzgerät empfangener Anregungsantworten ermittelt wird.

12. Verfahren nach einem der vorangehenden Ansprüche, bei welchem im Rahmen der Temperaturregelung auch der Energieverbrauch der shimeisenseitigen Regeleinrichtungen berücksichtigt wird.

13. Verfahren nach einem der vorangehenden Ansprüche, bei welchem abhängig von dem wenigstens einen Informationssignal ein Temperatursollwert gewählt wird, auf den die Ist-Temperatur der Shimeisen eingeregelt wird.

14. Verfahren nach Anspruch 13, bei welchem der Sollwert aus einer Lookup-Tabelle gewählt wird.

15. Magnetresonanzgerät umfassend ein Gradientenspulensystem (22) sowie ein Shim-System (10) umfassend mehrere Shimeisen (14) mit jeweils einem zugeordneten Heizmittel (17) und Regelungseinrichtung (16),
**gekennzeichnet dadurch dass**
die Regelungseinrichtung (16) den Betrieb der Heizmittel (17) und damit die Temperatur der Shimeisen (14) in Abhängigkeit wenigstens eines eine Form- und/oder Lageänderung des Gradientenspulensystems (22) anzeigenden Informationssignals CI, 1', 1", 1') regelt.

16. Magnetresonanzgerät nach Anspruch 15, **dadurch gekennzeichnet, dass** die Regelungseinrichtungen (16) zum Regeln auf Basis eines ein Maß für einen Temperatur-Sollwert (S₁, S₂, ..., Sₙ) darstellenden Sollwertsignals, das in Abhängigkeit des Informationssignals (I, I', I'', I''') bestimmt ist, ausgebildet sind.

17. Magnetresonanzgerät nach Anspruch 16, **dadurch gekennzeichnet, dass** eine Steuerungseinrichtung (18) zum Bestimmen des Temperatur-Sollwerts (S₁, S₂, ..., Sₙ) und damit des Sollwertsignals vorgesehen ist, der das oder die Informationssignale (I, I', I'', I''') gegeben werden und die mit den Regelungseinrichtungen (16) kommuniziert.

18. Magnetresonanzgerät nach Anspruch 17, **dadurch gekennzeichnet, dass** in der Steuerungseinrichtung (18) eine Lookup-Tabelle (20) abgelegt ist, aus der in Abhängigkeit des oder der Informationssignale (I, I', I'', I''') der Temperatur-Sollwert (S₁, S₂, ..., Sₙ) gewählt und in Form des Sollwertsignals an die Regelungseinrichtungen (16) gegeben wird.

19. Magnetresonanzgerät nach einem der Ansprüche 15 bis 18, **dadurch gekennzeichnet, dass** jedem Shimeisen (14) zwei regelbare Heizmittel (17) zugeordnet sind, die an einander gegenüberliegenden Seiten des Shimeisens (17) angeordnet und über eine gemeinsame oder separate Regelungseinrichtungen (16) separat geregelt werden.

20. Magnetresonanzgerät nach einem der Ansprüche 15 bis 19, **dadurch gekennzeichnet, dass** ein oder mehrere Messelemente zur Erfassung des oder der Informationssignale (I, I', I", I"') vorgesehen sind, die gegebenenfalls mit der Steuerungseinrichtung (18) kommunizieren.

21. Magnetresonanzgerät nach Anspruch 20, **dadurch gekennzeichnet, dass** das oder die Messelemente zur Erfassung des oder der mittels des Gradientenspulensystems (22) erzeugten Magnetfelder ausgebildet sind.

22. Magnetresonanzgerät nach Anspruch 20 **dadurch gekennzeichnet, dass** das oder die Messelemente zur Erfassung der Temperatur des Gradientenspulensystems (22) ausgebildet sind.

23. Magnetresonanzgerät nach Anspruch 20, **dadurch gekennzeichnet, dass** das oder die Messelemente am Gradientenspulensystem (22) angeordnete Dehnungssensoren sind.

24. Magnetresonanzgerät nach einem der Ansprüche 20 bis 23, **dadurch gekennzeichnet, dass** die mehreren Messelemente über das Gradientenspulensystem (22) vorzugsweise homogen verteilt angeordnet sind, so dass lokal aufgelöste Informationssignale erfasst werden.

25. Magnetresonanzgerät nach Anspruch 24, **dadurch gekennzeichnet, dass** die mehreren Messelemente an der Außenseite und der Innenseite der Gradientenspulensystems (22) vorzugsweise homogen verteilt angeordnet sind, so dass lokal ortsaufgelöste Informationssignale von der Außenseite und der Innenseite erfasst werden.

26. Magnetresonanzgerät nach einem der Ansprüche 15 bis 25 **dadurch gekennzeichnet, dass** als Informationssignal wenigstens ein Betriebsparameter des Gradientenspulensystems (22) dient.

27. Magnetresonanzgerät nach Anspruch 26, **dadurch gekennzeichnet, dass** als Betriebsparameter der Betriebsstrom des Gradientenspulensystems dient.

28. Magnetresonanzgerät nach Anspruch 27, **dadurch gekennzeichnet, dass** als weiterer Betriebsparameter ein ein Maß für die Kühlung des Gradientenspulensystems (22) darstellender Betriebsparameter verwendet wird.

29. Magnetresonanzgerät nach einem der Ansprüche 15 bis 28, **dadurch gekennzeichnet, dass** Mittel zur Ermittlung des Informationssignals durch eine Analyse eines oder mehrerer mit dem Magnetresonanzgerät (1) aufgenommener Anregungsantworten vorgesehen sind, die gegebenenfalls mit der Steuerungseinrichtung (18) kommunizieren.

30. Magnetresonanzgerät nach einem der 15 bis 29, **dadurch gekennzeichnet, dass** die Temperaturregelung unter Berücksichtigung auch des Energieverbrauchs der shimeisenseitigen Regeleinrichtungen (16) erfolgt.

31. Magnetresonanzgerät nach einem der Ansprüche 15 bis 30, **dadurch gekennzeichnet, dass** die Heizmittel (17) als Folienheizung mit einer Trägerfolie mit aufgebrachten Heizleitern, Platinenheizung mit einer Trägerplatine mit aufgebrachten Heizleitern oder als Substratheizung mit einem vorzugsweise keramischen, insbesondere Al₂O₃-Substrat mit aufgebrachten Heizleitern oder als Hybrid direkt auf dem Shimeisen (14) ausgebildet sind.

32. Magnetresonanzgerät nach Anspruch 31, **dadurch gekennzeichnet, dass** die Heizleiter zur Unterdrückung von während ihres Betriebs erzeugbaren Magnetfeldern bifilar verlaufend angeordnet sind.

## Claims

1. Method for the operation of a magnetic resonance apparatus comprising a gradient coil system as well as a shim system with a number of shim irons, each of which is assigned a heater,
**characterised in that**
at least one information signal indicating a change in shape and/or position of the gradient coil system is determined or employed, the regulation of the heater and thus the temperature of the shim irons is carried out dependent on the information signal.

2. Method according to claim 1, with which the information signal or signals are determined using one or more measurement elements.

3. Method according to claim 2, with which the measurement element or elements acquire the magnetic field or fields generated with the gradient coil system.

4. Method according to claim 2, with which the measurement element or elements acquire the temperature of the gradient coil system.

5. Method according to claim 2, with which strain sensors, which supply information signals and are arranged on the gradient coil system are employed as measurement elements,.

6. Method according to one of claims 2 to 5, with which the number of measurement elements are preferably arranged uniformly distributed over the gradient coil system, so that locally resolved information signals are acquired.

7. Method according to claim 6, with which the number of measurement elements are arranged, preferably uniformly distributed at, the outside and the inside of the gradient coil system, so that locally resolved information signals from the outside and the inside can be acquired.

8. Method according to one of the preceding claims, with which at least one operating parameter of the gradient coil system is employed as an information signal.

9. Method according to claim 8, with which the operating current of the gradient coil system is employed as an operating parameter.

10. Method according to claim 9, with which an operating parameter that represents a criterion for the cooling of the gradient coil system is employed as a further operating parameter.

11. Method according to one of the preceding claims, with which the information signal is determined by analysing one or more excitation responses received with the magnetic resonance apparatus.

12. Method according to one of the preceding claims, with which the energy consumption of the regulating devices for the shim iron is also considered within the scope of the temperature regulation.

13. Method according to one of the preceding claims, with which a reference temperature value is selected, to which value the actual temperature of the shim irons is adjusted, as a function of the at least one information signal.

14. Method according to claim 13, with which the reference value is selected from a lookup table.

15. Magnetic resonance apparatus comprising a gradient coil system (22) as well as a shim system (10) having a number of shim irons (14), each being assigned a heater (17) and regulating device (16), **characterised in that**
the regulating device (16) regulates the operation of the heater (17) and thus the temperature of the shim irons (14) as a function of at least one information signal (I, 1', 1", 1') indicating a change in shape and/or position of the gradient coil system (22).

16. Magnetic resonance apparatus according to claim 15, **characterised in that** the regulating devices (16) are designed to regulate on the basis of a reference value signal representing a criterion for a reference temperature value (S₁, S₂,...S*ₙ*), the reference value signal being defined dependent on the information signal (I, I', I'', I''').

17. Magnetic resonance apparatus according to claim 16, **characterised in that** a control device (18) is provided to determine the reference temperature value (S₁, S₂,...S*ₙ*) and thus the reference value signal, which provide the information signal or signals (I, I', I", I"') and which communicates with the regulating devices (16).

18. Magnetic resonance apparatus according to claim 17, **characterised in that** a lookup table (20) is stored in the control device (18), from which the reference temperature value (S₁, S₂,...S*ₙ*) is selected as a function of the information signal or signals (I, I', I", I"') and is provided to the regulating devices (16) in the form of the reference value signal.

19. Magnetic resonance apparatus according to one of claims 15 to 18, **characterised in that** two regulatable heaters (17) are assigned to each shim iron (14), said heaters being arranged at opposite sides of the shim iron (17) and being separately regulated via the common or separate regulating devices (16).

20. Magnetic resonance apparatus according to one of claims 15 to 19, **characterised in that** one or more measurement elements are provided to acquire the information signal of signals (I, I', I", I"'), which communicate if necessary with the control device (18).

21. Magnetic resonance apparatus according to claim 20, **characterised in that** the measurement element or elements are configured to acquire the magnet field or fields generated by means of the gradient coil system (22).

22. Magnetic resonance apparatus according to claim 20, **characterised in that** the measurement element or elements are configured to acquire the temperature of the gradient coil system (22).

23. Magnetic resonance apparatus according to claim 20, **characterised in that** the measurement element or elements are strain sensors arranged on the gradient coil system (22).

24. Magnetic resonance apparatus according to one of claims 20 to 23, **characterised in that** the number of measurement elements are preferably arranged uniformly distributed over the gradient coil system (22), so that locally resolved information signals are acquired.

25. Magnetic resonance apparatus according to claim 24, **characterised in that** the number of measurement elements are arranged preferably uniformly distributed at the outside and the inside of the gradient coil system (22), so that locally resolved information signals from the outside and the inside are acquired.

26. Magnetic resonance apparatus according to one of claims 15 to 25, **characterised in that** at least one operating parameter of the gradient coil system (22) is employed as an information signal.

27. Magnetic resonance apparatus according to claim 26, **characterised in that** the operating current of the gradient coil system is employed as an operating parameter.

28. Magnetic resonance apparatus according to claim 27, **characterised in that** an operating parameter that represents a criterion for the cooling of the gradient coil system (22) is employed as a further operating parameter.

29. Magnetic resonance apparatus according to one of claims 15 to 28, **characterised in that** an analysis unit is provided for determining the information signal by an analysis of one or more excitation responses registered with the magnetic resonance apparatus, the analysis unit communicating as warranted with the control device (18).

30. Magnetic resonance apparatus according to one of claims 15 to 29, **characterised in that** the temperature regulation is also carried out in consideration of the energy consumption of the regulating devices (16) for the shim iron.

31. Magnetic resonance apparatus according to one of claims 15 to 30, **characterised in that** the heaters (17) are embodied as a foil heater having a carrier foil with heat conductors applied thereon, as a plate heater having a carrier plate with heat conductors applied thereon or as a substrate heater with a ceramic, particularly AL₂O₃ substrate with heat conductors applied thereon, or as a hybrid directly on the shim iron (14).

32. Magnetic resonance apparatus according to claim 31, **characterised in that** the heat conductors are arranged to proceed in a bifilar fashion for suppression magnetic fields that may be generated during their operation.

## Revendications

1. Procédé pour faire fonctionner un appareil de résonance magnétique comprenant un système de bobine à gradient ainsi qu'un système shim comprenant plusieurs fers shim ayant, respectivement, un moyen de chauffage associé,
**caractérisé en ce que**
on détermine ou on utilise au moins un signal d'information indiquant une modification de forme et/ou de position du système de bobine à gradient, signal en fonction duquel s'effectue la régulation du moyen de chauffage et ainsi de la température des fers shim.

2. Procédé suivant la revendication 1, dans lequel on détermine le ou les signaux d'information en utilisant un ou plusieurs éléments de mesure.

3. Procédé suivant la revendication 2, dans lequel le ou les éléments de mesure déterminent le ou les champs magnétiques produits au moyen du système de bobine à gradient.

4. Procédé suivant la revendication 2, dans lequel le ou les éléments de mesure relèvent la température du système de bobine à gradient.

5. Procédé suivant la revendication 2, dans lequel on utilise comme élément de mesure des capteurs de dilatation disposés sur le système de bobine à gradient et fournissant les signaux d'information.

6. Procédé suivant l'une des revendications 2 à 5, dans lequel on répartit de préférence de manière uniforme les plusieurs éléments de mesure sur le système de bobine à gradient de manière à relever des signaux d'information résolus spatialement localement.

7. Procédé suivant la revendication 6, dans lequel on répartit de préférence d'une manière uniforme les plusieurs éléments de mesure sur le côté extérieur et le côté intérieur du système de bobine à gradient de manière à relever du côté extérieur et du côté intérieur des signaux d'information résolus spatialement localement.

8. Procédé suivant l'une des revendications précédentes, dans lequel on utilise comme signal d'information au moins un paramètre de fonctionnement du système de bobine à gradient.

9. Procédé suivant la revendication 8, dans lequel on utilise comme paramètre de fonctionnement le courant de fonctionnement du système de bobine à gradient.

10. Procédé suivant la revendication 9, dans lequel on utilise comme autre paramètre de fonctionnement un paramètre de fonctionnement représentant une mesure du refroidissement du système de bobine à gradient.

11. Procédé suivant l'une des revendications précédentes, dans lequel on détermine le signal d'information par une analyse d'une ou de plusieurs réponses d'excitation reçues par l'appareil de résonance magnétique.

12. Procédé suivant l'une des revendications précédentes, dans lequel on tient compte dans le cadre de la régulation de la température également de la consommation d'énergie des dispositifs de régulation du côté des fers shim.

13. Procédé suivant l'une des revendications précédentes, dans lequel on choisit indépendant du au moins un signal d'information une valeur de consigne de la température, sur laquelle on règle la température réelle des fers shim.

14. Procédé suivant la revendication 13, dans lequel on choisit la valeur de consigne dans une table.

15. Appareil de résonance magnétique comprenant un système (22) de bobine à gradient ainsi qu'un système (10) shim comprenant plusieurs fers (14) shim ayant, respectivement, un moyen (17) de chauffage associé et un dispositif (16) de régulation,
**caractérisé en ce que**
le dispositif (16) de régulation régule le fonctionnement du moyen (17) de chauffage et ainsi la température des fers (14) shim en fonction d'au moins un signal (I, I' , I" , I"') d'information indiquant une modification de forme et/ou de position du système (22) de bobine à gradient.

16. Appareil de résonance magnétique suivant la revendication 15, **caractérisé en ce que** les dispositifs (16) de régulation sont conçus pour la régulation sur la base d'un signal de valeur de consigne représentant une mesure d'une valeur de consigne de température (S1, S2, ..., Sn) qui est déterminée en fonction du signal (I, I', I", I"') d'information.

17. Appareil de résonance magnétique suivant la revendication 16, **caractérisé en ce qu'**il est prévu un dispositif (18) de commande pour déterminer la valeur de consigne de température (S1, S2, ..., Sn), et ainsi le signal de valeur de consigne, qui est donnée par le ou les signaux (I, I', I'', I"') d'information, et qui communique avec les dispositifs (16) de régulation.

18. Appareil de résonance magnétique suivant la revendication 17, **caractérisé en ce qu'**il est mémorisé dans le dispositif (18) de commande une table (20) dans laquelle est choisie en fonction du ou des signaux (I, I', I'', I''') d'information la valeur de consigne de température (S1, S2, ..., Sn) qui est envoyée sous la forme du signal de valeur de consigne aux dispositifs (16) de régulation.

19. Appareil de résonance magnétique suivant l'une des revendications 15 à 18, **caractérisé en ce qu'**il est associé à chaque fer (14) shim deux moyens (17) de chauffage réglables qui sont disposés sur des côtés mutuellement opposés du fer (17) shim et qui sont réglés séparément par un dispositif (16) de régulation commun ou par des dispositifs (16) de régulation distincts.

20. Appareil de résonance magnétique suivant l'une des revendications 15 à 19, **caractérisé en ce qu'**il est prévu pour la détection du ou des signaux (I, I', I", I"') d'information un ou plusieurs éléments de mesure qui communiquent le cas échéant avec le dispositif (18) de commande.

21. Appareil de résonance magnétique suivant la revendication 20, **caractérisé en ce que** le ou les éléments de mesure sont conçus pour la détection du ou des champs magnétiques produits au moyen du système (22) de bobine à gradient.

22. Appareil de résonance magnétique suivant la revendication 20, **caractérisé en ce que** le ou les éléments de mesure sont conçus pour la détection de la température du système (22) de bobine à gradient.

23. Appareil de résonance magnétique suivant la revendication 20, **caractérisé en ce que** le ou les éléments de mesure sont des capteurs de dilatation disposés sur le système (22) de bobine à gradient.

24. Appareil de résonance magnétique suivant l'une des revendications 20 à 23, **caractérisé en ce que** les plusieurs éléments de mesure sont répartis de manière de préférence uniforme sur le système (22) de bobine à gradient de manière à détecter des signaux d'information résolus spatialement localement.

25. Appareil de résonance magnétique suivant la revendication 24, **caractérisé en ce que** les plusieurs éléments de mesure sont répartis de préférence de manière uniforme sur le côté extérieur et le côté intérieur du système (22) de bobine à gradient de manière à détecter du côté extérieur et du côté intérieur des signaux d'information résolus spatialement localement.

26. Appareil de résonance magnétique suivant l'une des revendications 15 à 25, **caractérisé en ce qu'**au moins un paramètre de fonctionnement du système (22) de bobine à gradient sert de signal d'information.

27. Appareil de résonance magnétique suivant la revendication 26, **caractérisé en ce que** le courant de fonctionnement du système de bobine à gradient sert de paramètre de fonctionnement.

28. Appareil de résonance magnétique suivant la revendication 27, **caractérisé en ce qu'**un paramètre de fonctionnement représentant une mesure du refroidissement du système (22) de bobine à gradient est utilisé comme autre paramètre de fonctionnement.

29. Appareil de résonance magnétique suivant l'une des revendications 15 à 28, **caractérisé en ce qu'**il est prévu des moyens de détermination du signal d'information par une analyse d'une ou de plusieurs réponses d'excitation enregistrées par l'appareil (1) de résonance magnétique, moyen qui communique le cas échéant avec le dispositif (18) de commande.

30. Appareil de résonance magnétique suivant l'une des revendications 15 à 29, **caractérisé en ce que** la régulation de température s'effectue en tenant compte également de la consommation d'énergie des dispositifs (16) de régulation du côté des fers shim.

31. Appareil de résonance magnétique suivant l'une des revendications 15 à 30, **caractérisé en ce que** les moyens (17) de chauffage sont conçus directement sur les fers (14) shim sous la forme d'un chauffage en feuille comprenant une feuille support sur laquelle sont déposés des conducteurs chauffants, d'un chauffage à platine comprenant une platine support sur laquelle sont déposés des conducteurs chauffants ou sous la forme d'un chauffage par substrat ayant un substrat de préférence en céramique, notamment en Al₂O₃, sur lequel sont déposés des conducteurs chauffants ou sous la forme d'un hybride.

32. Appareil de résonance magnétique suivant la revendication 31, **caractérisé en ce que** les conducteurs chauffants sont disposés en s'étendant de manière bifilaire pour supprimer des champs magnétiques pouvant être produits pendant leur fonctionnement.
